# EUROPEAN PATENT APPLICATION

(11) **EP 4 471 835 A1**
(43) Date of publication of application: **04.12.2024**
(21) Application number: 22923725.0
(22) Date of filing: 25.01.2022
(51) Int. Cl.: H01L 21/56

(54) **RESIN SEALING DEVICE, SEALING MOLD, AND RESIN SEALING METHOD**

(71) Applicant: Apic Yamada Corporation, Chikuma-shi, Nagano 389-0898 (JP)
(72) Inventor: SAITO, Takashi, Chikuma-shi, Nagano 389-0898 (JP); OHASHI, Konomi, Chikuma-shi, Nagano 389-0898 (JP)
(74) Representative: Becker, Eberhard
(86) International application number: PCT/JP2022/002496
(87) International publication number: WO 2023/144856

(57) **Abstract**

The purpose of the present invention is to provide a sealing mold that realizes, with a simple structure, a vertical movement mechanism for setting pins. As a solution, a sealing mold (202) according to the present invention includes a vertically movable support plate (215) between a chase block (213) and a plate (251), wherein: the support plate (215) has support members (221) that support a workpiece (W); and a pushing pin (226) is provided so as to be supported by a plate (252), the pushing pin pushing the support plate (215) away from a cavity plate (211) when the plate (251) and the plate (252) are put in a state in which said plates are brought even closer to each other from a state in which the mold is closed.

## Description

### Technical Field

The present invention relates to a resin sealing device, a sealing mold, and a resin sealing method for sealing a workpiece with resin.

### Related Art

Examples of resin sealing devices and resin sealing methods that seal a workpiece having electronic components mounted on a base material with sealing resin (hereinafter may be simply referred to as "resin") and process them into a molded product include devices and methods implemented using a transfer molding system.

The transfer molding system is a technique for sealing with resin by providing a pot to supply a predetermined amount of resin to a pair of sealing regions (cavities) provided in a sealing mold that includes an upper mold and a lower mold, respectively placing workpieces at positions corresponding to the sealing regions, clamping the upper mold and the lower mold, and pouring resin from the pot into the cavities (see Patent Document 1: Japanese Patent Application Laid-Open No. 6-37130, and Patent Document 2: Japanese Patent Application Laid-Open No. 2000-3923).

### Citation List

### Patent Documents

[Patent Document 1] Japanese Patent Application Laid-Open No. 6-37130
[Patent Document 2] Japanese Patent Application Laid-Open No. 2000-3923

### SUMMARY OF INVENTION

### Technical Problem

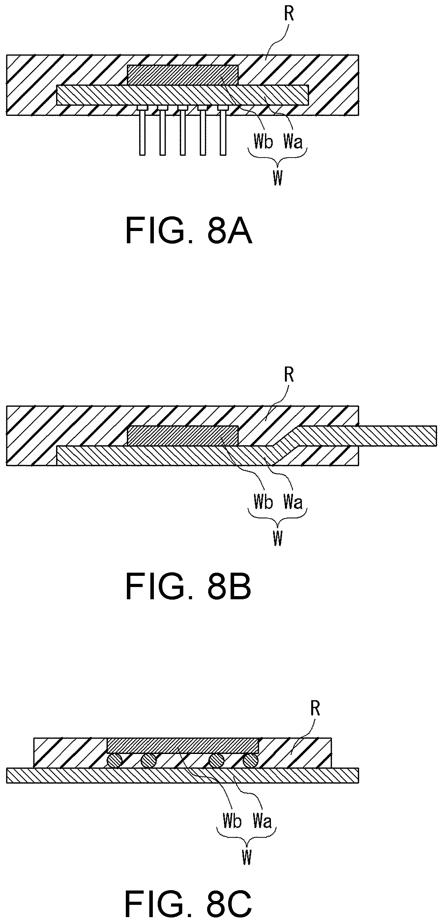

The workpieces to be resin-sealed have various configurations, such as the workpiece W in which the entire periphery of the base material Wa and the electronic component Wb is sealed with resin R (excluding terminal parts or the like) as shown in FIG. 8A, and the workpiece W which is sealed with resin R so that one surface of the base material Wa (or electronic component Wb) is exposed as shown in FIG. 8B. When sealing such a workpiece with resin using the transfer molding system, it is impossible or difficult to clamp the workpiece (specifically, the base material) and the workpiece may shift from a predetermined position.

To solve the above problem, in the conventional transfer molding system, a technique is disclosed to hold the workpiece in the cavity by clamping the workpiece using a vertically movable support member (support pin), and release the clamping by moving the support member vertically at a predetermined timing during resin filling so as to prevent the workpiece from shifting from the predetermined position (see Patent Documents 1 and 2).

However, the vertical movement mechanism for the support member in the conventional device has generally been configured to include a dedicated drive mechanism such as a motor, an air cylinder, or the like. Therefore, the structure of the device is complicated and the cost of the device increases.

### Solution to Problem

In view of the above circumstances, an object of the present invention is to provide a resin sealing device, a sealing mold, and a resin sealing method using a transfer molding system, including a configuration that seals a workpiece with resin by clamping and releasing the workpiece using a vertically movable support member, realizing a vertical movement mechanism of the support member by a configuration that uses a mold closing mechanism instead of a large-scale dedicated drive mechanism, and being capable of simplifying the device structure and suppressing the device cost.

The present invention solves the above-mentioned problem by means of a solution as described below as an embodiment.

A sealing mold according to the present invention includes an upper mold and a lower mold and processes a workpiece into a molded product by sealing the workpiece with resin. The sealing mold includes: a cavity plate which is disposed in at least one of the upper mold and the lower mold and has a cavity; a chase block to which the cavity plate is fixed or which is formed integrally with the cavity plate; one plate of a top plate and a bottom plate of upper and lower molds which applies a pushing force to the chase block in a direction of performing mold closing of the upper mold and the lower mold; an other plate which is disposed in pair with the one plate and operates together to perform the mold closing; and a support plate which is disposed at a position between the chase block and the one plate to be vertically movable, in which the support plate includes a support member that is disposed and inserted through the cavity plate and the chase block and supports the workpiece, and a pushing pin that pushes the support plate in a direction away from the cavity plate in response to the one plate and the other plate being further brought close to each other from a mold closed state is provided to be supported by the other plate.

According to this, the workpiece is held in the cavity in a clamped state using the vertically movable support member, and the clamping is released by moving the support member vertically at a predetermined timing during resin filling, which makes it possible to seal the workpiece with resin without causing the workpiece to shift from a predetermined position. Further, the mechanism for moving the support member vertically can be realized by a configuration that uses the mold closing mechanism without providing a large-scale dedicated drive mechanism. Therefore, the device structure can be simplified and the device cost can be suppressed. Furthermore, mold underfill molding can be suitably performed.

Moreover, it is preferable to further include a support urging member that urges the support plate in a direction toward the chase block. According to this, the position of the support plate can be maintained so that the tip portion of the support member can abut against the workpiece, so the workpiece can be clamped at the tip portion of the support member during mold closing.

Further, it is preferable to further include a control pin that regulates movement of the other plate to define a pushing amount by which the pushing pin pushes the support plate in response to the one plate and the other plate being further brought close to each other from the mold closed state. According to this, it is possible to set the amount of movement of the support plate, that is, the amount of movement of the support member fixed to the support plate.

Further, it is preferable that the support plate includes a set pin that is inserted through the cavity plate and the chase block and disposed to be capable of abutting against the pushing pin and transmits a pushing force of the pushing pin to the support plate. Here, it is preferable that the set pin is disposed so that a tip surface that abuts against the pushing pin is in the same plane as a mold surface of the cavity plate. According to this, the configuration can be made so that the tip portion of the pushing pin does not protrude from the mold surface in the mold opened state. Therefore, the amount of mold opening can be minimized, and an increase in takt time can be suppressed. Moreover, even if malfunction or insufficient adjustment occurs, collision between the in loader, the out loader, and the pushing pin can be prevented.

Further, it is preferable to further include an eject plate that is disposed to be vertically movable at a position between the chase block and the one plate and at a position on either the chase block side or the one plate side with respect to the support plate, and the eject plate includes an eject pin that is inserted through the cavity plate and the chase block to be capable of abutting against the molded product. According to this, the molded product can be taken out from the cavity when the mold is opened.

Further, a sealing mold according to the present invention includes an upper mold and a lower mold and processes a workpiece into a molded product by sealing the workpiece with resin. The sealing mold includes: a cavity plate which is disposed in the upper mold and has a cavity; a chase block to which the cavity plate is fixed or which is formed integrally with the cavity plate; one plate of a top plate and a bottom plate of upper and lower molds which applies a pushing force to the chase block in a direction of performing mold closing of the upper mold and the lower mold; an other plate which is disposed in pair with the one plate and operates together to perform the mold closing; and a support plate which is disposed at a position between the chase block and the one plate to be vertically movable, in which the support plate includes a support member that is disposed and inserted through the cavity plate and the chase block and forms the cavity, and a pushing pin that pushes the support plate in a direction away from the cavity plate in response to the one plate and the other plate being further brought close to each other from a mold closed state is provided to be supported by the other plate. Alternatively, a sealing mold according to the present invention includes an upper mold and a lower mold and processes a workpiece into a molded product by sealing the workpiece with resin. The sealing mold includes: a cavity plate which is disposed in the lower mold and has a cavity; a chase block to which the cavity plate is fixed or which is formed integrally with the cavity plate; one plate of a top plate and a bottom plate of upper and lower molds which applies a pushing force to the chase block in a direction of performing mold closing of the upper mold and the lower mold; an other plate which is disposed in pair with the one plate and operates together to perform the mold closing; and a support plate which is disposed at a position between the chase block and the other plate to be vertically movable, in which the support plate includes a support member that is disposed and inserted through the cavity plate and the chase block and forms the cavity, and a pushing pin that pushes the support plate in a direction away from the cavity plate in response to the one plate and the other plate being further brought close to each other from a mold closed state is provided to be supported by the one plate. According to this, mold underfill molding can be suitably performed.

Further, a resin sealing device according to the present invention includes the sealing mold.

Further, a resin sealing method according to the present invention processes a workpiece into a molded product by sealing the workpiece with resin using a resin sealing device that includes: a cavity plate which is disposed in at least one of an upper mold and a lower mold that form a sealing mold and has a cavity; a chase block to which the cavity plate is fixed; one plate of a top plate and a bottom plate of upper and lower molds which pushes the chase block; an other plate which is disposed in pair with the one plate and operates together to perform mold closing of the sealing mold; and a support plate which is disposed at a position between the chase block and the one plate to be vertically movable. The resin sealing method includes: a step of supporting the workpiece in a state of floating from a bottom of the cavity using a support member that is disposed on the support plate; next, a step of performing mold closing of the sealing mold by bringing the one plate and the other plate close to each other; next, a step of filling the resin into the cavity; and next, a step of pushing the support plate in a direction away from the cavity plate using a pushing pin disposed on the other plate to release the workpiece from support of the support member by further bringing the one plate and the other plate close to each other from a mold closed state in response to a filling rate of the resin in the cavity reaches an arbitrary set value of 70% to 100%.

### Effects of Invention

According to the present invention, the workpiece can be clamped and released using the vertically movable support member, so it is possible to seal the workpiece with resin without causing the workpiece to shift from a predetermined position. In addition, since the vertical movement mechanism of the support member can be realized by a configuration that uses the mold closing mechanism without providing a large-scale dedicated drive mechanism, the device structure can be simplified and the device cost can be suppressed. Furthermore, mold underfill molding can be suitably performed.

### BRIEF DESCRIPTION OF DRAWINGS

[FIG. 1] FIG. 1 is a plan view showing an example of the resin sealing device according to an embodiment of the present invention.
[FIG. 2] FIG. 2 is a side view at a position along the line II-II in FIG. 1.
[FIG. 3] FIG. 3 is a side cross-sectional view showing an example of the sealing mold according to the first embodiment of the present invention.
[FIG. 4] FIG. 4 is an explanatory view (side cross-sectional view) of the operation of the resin sealing device including the sealing mold shown in FIG. 3.
[FIG. 5] FIG. 5 is an explanatory view (side cross-sectional view) of the operation following FIG. 4.
[FIG. 6] FIG. 6 is an explanatory view (side cross-sectional view) of the operation following FIG. 5.
[FIG. 7] FIG. 7 is an explanatory view (side cross-sectional view) of the operation following FIG. 6.
[FIG. 8] FIG. 8A to FIG. 8C are cross-sectional views showing examples of the workpieces to be resin-sealed.
[FIG. 9] FIG. 9 is a side cross-sectional view showing an example of the sealing mold according to the second embodiment of the present invention.
[FIG. 10] FIG. 10 is an explanatory view (side cross-sectional view) of the operation of the resin sealing device including the sealing mold shown in FIG. 9.
[FIG. 11] FIG. 11 is an explanatory view (side cross-sectional view) of the operation following FIG. 10.
[FIG. 12] FIG. 12A and FIG. 12B are side cross-sectional views showing an example of the cavity of the sealing mold shown in FIG. 9.
[FIG. 13] FIG. 13A and FIG. 13B are side cross-sectional views showing an example of the cavity of the sealing mold shown in FIG. 9.
[FIG. 14] FIG. 14A and FIG. 14B are side cross-sectional views showing another example of the cavity of the sealing mold shown in FIG. 9.

### DESCRIPTION OF EMBODIMENTS

### [First embodiment]

### (Overall configuration)

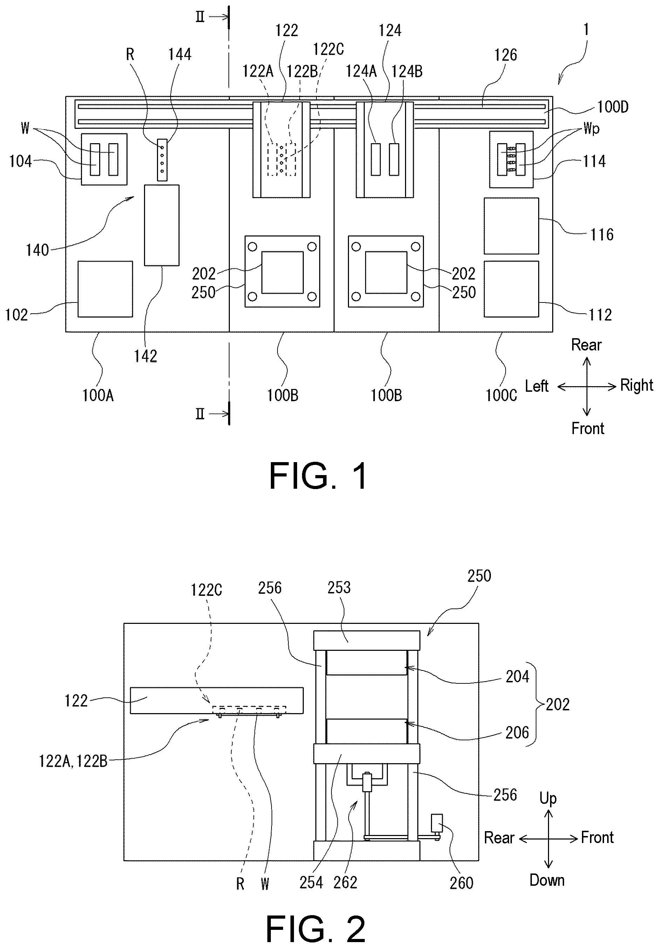

Hereinafter, the first embodiment of the present invention will be described in detail with reference to the drawings. FIG. 1 is a plan view (schematic view) showing an example of a resin sealing device 1 according to an embodiment of the present invention. For convenience, the front-rear, left-right, and up-down directions of the resin sealing device 1 may be described using the arrows in the drawings. In addition, in all the drawings for describing each embodiment, members having the same function may be denoted by the same reference numerals, and repeated description thereof may be omitted.

This resin sealing device 1 is a device that uses a sealing mold 202 including an upper mold 204 and a lower mold 206 to seal a workpiece (object to be molded) W with resin and process the workpiece W into a molded product Wp. As the sealing mold 202 and the resin sealing device 1 according to this embodiment, a resin sealing device using a transfer molding system will be described hereinafter as an example, which includes a configuration having a cavity 207 in the upper mold 204 and a cavity 208 and a pot (not shown) in the lower mold 206, and seals the workpiece W with resin by closing the upper mold 204 and the lower mold 206 and filling resin R in the pot into the cavities 207 and 208. However, the resin sealing device 1 is not limited to this configuration, and can also be configured to have a cavity in only one of the upper mold 204 and the lower mold 206 (not shown).

First, the workpiece W to be molded has a configuration in which a plurality of electronic components Wb are mounted in a predetermined arrangement on a base material Wa. More specifically, examples of the base material Wa include plate-shaped members such as resin substrates, ceramic substrates, metal substrates, carrier plates, lead frames, wafers, and heat sinks (heat dissipation members) formed in rectangular or circular shapes. Further, examples of the electronic component Wb include semiconductor chips, MEMS chips, passive elements, conductive members, spacers, heat sinks (heat dissipation members), and combinations thereof. However, the electronic component Wb is not limited to these.

Examples of the method for mounting the electronic component Wb on the base material Wa include mounting methods such as wire bonding mounting and flip-chip mounting. Alternatively, in the case of a configuration in which the base material (carrier plate made of glass or metal) Wa is peeled off from the molded product Wp after resin sealing, there is also a method of attaching the electronic component Wb using an adhesive tape having thermal releasability or ultraviolet curable resin that is cured by ultraviolet irradiation.

On the other hand, examples of the resin R include tablet-shaped (for example, columnar) thermosetting resin (for example, filler-containing epoxy resin or the like). Nevertheless, the resin R is not limited to the above state, and may have a shape other than a columnar shape and may be resin other than epoxy thermosetting resin.

Next, an overview of the resin sealing device 1 according to this embodiment will be described. As shown in FIG. 1, the resin sealing device 1 includes, as the main configuration, a supply unit 100A that mainly supplies the workpiece W to be resin-sealed and the resin R, a press unit 100B that mainly processes the workpiece W into the molded product Wp by resin-sealing, and a storage unit 100C that mainly stores the resin-sealed molded product Wp.

The resin sealing device 1 further includes a transport mechanism 100D that moves between the units and transports the workpiece W, the resin R, and the molded product Wp. As an example, the transport mechanism 100D includes an in loader 122 that transports the workpiece W and the resin R into the press unit 100B, an out loader 124 that transports the molded product Wp out of the press unit 100B, and a guide rail 126 that is shared by the in loader 122 and the out loader 124. Nevertheless, the transport mechanism 100D is not limited to the above configuration, and may be configured to use a known pickup or the like in combination as appropriate (not shown). Furthermore, instead of the configuration including the loaders, a configuration including an articulated robot may be used (not shown).

Here, the in loader 122 functions to receive the workpiece W and the resin R in the supply unit 100A and transport the same to the press unit 100B. As a configuration example of the in loader 122, workpiece holding portions 122A and 122B are provided, which are arranged in two rows in parallel along the left-right direction and can each hold one workpiece W. Further, a resin holding portion 122C that can hold a plurality of pieces of resin R (a case of four pieces is illustrated as an example, but the present invention is not limited thereto; alternatively, there may be one single piece of resin R) in the front-rear direction is provided at a position between the two rows of workpiece holding portions 122A and 122B. In addition, a known holding mechanism (for example, a configuration that clamps with holding claws, a configuration that sucks with a suction hole communicating with a suction device, etc.) is used (not shown) in the workpiece holding portions 122A and 122B and the resin holding portion 122C.

The in loader 122 according to this embodiment is configured to move in the left-right direction and the front-rear direction to transport the workpiece W and the resin R into the sealing mold 202 and place the workpiece W and the resin R at a predetermined position in the lower mold 206. However, the present invention is not limited thereto, and may also be configured to separately include a loader that moves in the left-right direction to transport the workpiece and resin between the units and a loader that moves in the front-rear direction to transport the workpiece and resin into the sealing mold 202 (not shown).

Furthermore, the out loader 124 functions to receive the molded product Wp (including unnecessary resin parts such as the cull part and the runner part) in the press unit 100B and transport the molded product Wp to the storage unit 100C. As a configuration example of the out loader 124, molded product holding portions 124A and 124B are provided, which are arranged in two rows in parallel in the left-right direction and can each hold one molded product Wp. In addition, a known holding mechanism (for example, a configuration that clamps with holding claws, a configuration that sucks with a suction hole communicating with a suction device, etc.) is used (not shown) in the molded product holding portions 124A and 124B.

The out loader 124 according to this embodiment is configured to move in the left-right direction and the front-rear direction to transport the molded product Wp out of the sealing mold 202 and place the molded product Wp on a molded product table 114. However, the present invention is not limited thereto, and may also be configured to separately include a loader that moves in the front-rear direction to transport the molded product out of the sealing mold 202 and a loader that moves in the left-right direction to transport the molded product between the units (not shown).

Besides, the overall configuration of the resin sealing device 1 can be changed by changing the configuration of the units. For example, although the configuration shown in FIG. 1 illustrates an example in which two press units 100B are installed, it is also possible to install only one press unit 100B or install three or more press units 100B. Furthermore, it is also possible to additionally install other units (neither is shown).

### (Supply unit)

Next, the supply unit 100A included in the resin sealing device 1 will be described.

The supply unit 100A includes, for example, a workpiece stocker 102 used to accommodate the workpiece W, and a workpiece table 104 on which the workpiece W is placed. In addition, the workpiece stocker 102 uses a known stack magazine, slit magazine, or the like, and can accommodate multiple workpieces W at once. With this configuration, workpieces W are taken out from the workpiece stocker 102 using a known pusher or the like (not shown) and placed on the workpiece table 104 (for example, a set of two workpieces W are placed in parallel). Next, the workpieces W placed on the workpiece table 104 are held by the in loader 122 and transported to the press unit 100B.

Further, the supply unit 100A (which may be another unit) includes a resin supply mechanism 140 that supplies the resin R at a side position of the workpiece table 104. As an example, the resin supply mechanism 140 includes a supply portion 142 that has a hopper, a feeder, or the like to supply the resin R, and a delivery portion 144 that has a transfer mechanism such as an elevator to hold multiple pieces of resin R supplied from the supply portion 142 at predetermined positions. With this configuration, the multiple pieces of resin R held in the delivery portion 144 are held by the in loader 122 and transported to the press unit 100B.

### (Press unit)

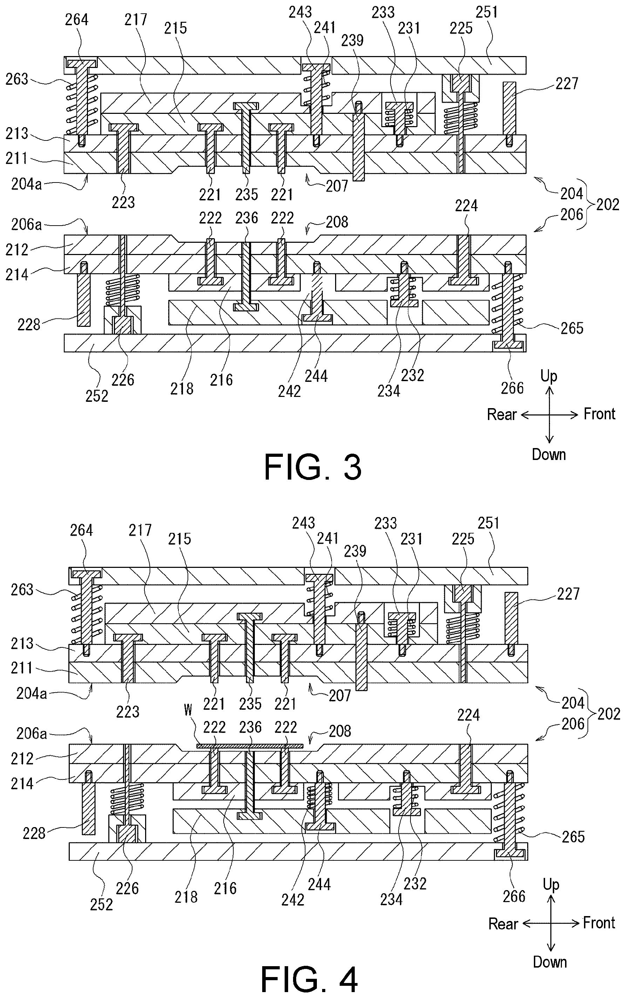

Next, the press unit 100B included in the resin sealing device 1 will be described. Here, FIG. 2 is a side view (schematic view) of a press device 250 of the resin sealing device 1, and FIG. 3 is a side cross-sectional view (schematic view) of the sealing mold 202.

The press unit 100B includes the press device 250 that drives the sealing mold 202 (details will be described later) to open and close to seal the workpiece W with resin. As shown in FIG. 2, the press device 250 includes a mold closing mechanism, which mainly includes the sealing mold 202 that has the lower mold 206 and the upper mold 204 and is disposed between a pair of fixed platen 253 and movable platen 254, a plurality of connection mechanisms 256 on which the pair of platens 253 and 254 are arranged, a drive source (for example, an electric motor) 260 that moves (raises and lowers) the movable platen 254, and a drive transmission mechanism (for example, a ball screw or toggle link mechanism) 262. In this embodiment, the upper mold 204 is assembled to the fixed platen 253, and the lower mold 206 is assembled to the movable platen 254. With this configuration, the mold is closed by moving the movable platen 254 in a direction approaching the fixed platen 253 (in this case, upward) and bringing a mold surface (the lower surface of a first cavity plate 211 described later) 204a of the upper mold 204 and a mold surface (the upper surface of a second cavity plate 212 described later) 206a of the lower mold 206 into contact with each other. However, the present invention is not limited to the above configuration, and the upper mold 204 may be assembled to the movable platen and the lower mold 206 may be assembled to the fixed platen, or the upper mold 204 and the lower mold 206 may both be assembled to movable platens (neither is shown).

Next, the upper mold 204 of the sealing mold 202 will be described in detail. As shown in FIG. 2 and FIG. 3, the upper mold 204 includes a cavity plate (first cavity plate) 211, a chase block (first chase block) 213, etc., and is configured by assembling these. In this embodiment, a cavity (first cavity) 207 in which the entire workpiece W or a predetermined portion thereof is accommodated is provided on the lower surface of the first cavity plate 211. This first cavity plate 211 is fixed to the lower surface of the first chase block 213. In addition, the first cavity plate and the first chase block may be configured as an integral member (not shown). Further, the first chase block 213 is supported by a top plate 251 and fixed at a predetermined distance from the top plate 251. However, the present invention is not limited to the above configuration.

Furthermore, the first cavity plate 211 or the first chase block 213 is provided with an upper mold heater (not shown). Thereby, the molten resin R filled in the resin flow path (not shown) and the cavity 207 can be heated to a predetermined temperature. As an example, a known heating wire heater, sheathed heater, or the like is used as the upper mold heater.

Further, the upper mold 204 includes a support plate (first support plate) 215 that is disposed at a position between the first chase block 213 and the top plate 251 so as to be vertically movable. The first support plate 215 includes a support member (first support pin) 221 that is disposed and inserted through the first cavity plate 211 and the first chase block 213 and can support the workpiece W in a state of suspending the workpiece W from the bottom of the first cavity 207. In addition, although a plurality of first support pins 221 (for example, four) according to this embodiment are provided for supporting one workpiece W, the present invention is not limited thereto.

Furthermore, a support urging member (first support urging member) 231 that urges the first support plate 215 in a direction toward the first chase block 213 is provided. Also, an urging member holder (first support urging member holder) 233 that holds the first support urging member 231 in a state of generating the urging force is provided and screwed onto the first chase block 213. Thereby, the first support plate 215 is in a state of abutting against the first chase block 213 in the mold opened state. In addition, as an example, a coil spring made of metal is used as the first support urging member 231, but the present invention is not limited thereto.

Here, as a mechanism for operating the first support plate 215, a pushing pin (first support plate pushing pin) 226 that pushes the first support plate 215 in a direction away from the first cavity plate 211 is provided and supported by a bottom plate 252 (described later). As an example, the first support plate pushing pin 226 is configured to be directly supported (fixed) with respect to the bottom plate 252, but the prevent invention is not limited thereto, and may be configured to be indirectly supported (fixed) through a connecting member or the like (not shown).

According to the above configuration, when further bringing the top plate 251 and the bottom plate 252 close to each other from the state where the upper mold 204 (in this case, the first cavity plate 211) and the lower mold 206 (in this case, the second cavity plate 212) abut against each other (that is, the mold closed state), the first support plate pushing pin 226 supported (fixed) by the bottom plate 252 generates an effect that the first support plate 215 is pushed in a direction away from the first cavity plate 211. Thereby, the first support plate 215 moves upward, and the first support pin 221 fixed to the first support plate 215 moves upward. That is, the workpiece W can be released from support of the first support pin 221.

Here, the first support plate 215 includes a set pin (first set pin) 223 that is inserted through the first cavity plate 211 and the first chase block 213 and disposed to be capable of abutting against the first support plate pushing pin 226, and transmits the pushing force of the first support plate pushing pin 226 to the first support plate 215. That is, in this embodiment, the first support plate 215 is pushed indirectly via the first set pin 223 fixed to the first support plate 215, instead of being directly pushed by the first support plate pushing pin 226.

At this time, the first set pin 223 is preferably disposed so that a tip surface (in this case, the lower end surface) that abuts against the first support plate pushing pin 226 is in the same plane as the lower surface (that is, the mold surface 204a) of the first cavity plate 211 in a state of not abutting against the first support plate pushing pin 226. According to such a configuration, the tip portion of the first support plate pushing pin 226 does not protrude from the mold surface 206a in the mold opened state. Therefore, the amount of mold opening can be minimized, and an increase in takt time can be suppressed. Furthermore, even if malfunction or insufficient adjustment occurs, collision between the in loader 122, the out loader 124, and the first support plate pushing pin 226 can be prevented. In addition, the first set pin 223 is not necessary, and for example, the first support plate pushing pin 226 may protrude from the mold surface 206a and directly push the first support plate 215.

Furthermore, in this embodiment, a control pin (first support plate control pin) 228 that defines the amount of movement of the first support plate 215, that is, the pushing amount by which the first support plate pushing pin 226 pushes the first support plate 215 is provided. As an example, the first support plate control pin 228 is configured to be directly supported (fixed) with respect to the second chase block 214 (described later), but the present invention is not limited thereto, and the first support plate control pin 228 may be configured to be indirectly supported (fixed) through a connecting member or the like. Further, the first support plate control pin 228 may be supported (fixed) by the bottom plate 252 instead of the second chase block 214 (neither is shown).

According to this configuration, at a time point when the top plate 251 and the bottom plate 252 are further brought close to each other from the mold closed state and the first support plate 215 pushed by the first support plate pushing pin 226 moves upward by a predetermined amount, the first support plate control pin 228 abuts against the bottom plate 252 and generates an effect of regulating movement of the bottom plate 252 (that is, movement of the first support plate 215). Thereby, the amount of movement of the first support plate 215 (that is, the first support pin 221) is defined. In addition, in the case where the first support plate control pin 228 is supported (fixed) by the bottom plate 252, the first support plate control pin 228 abuts against the second chase block 214 and generates the same effect.

Next, the upper mold 204 includes an eject plate (first eject plate) 217 that is disposed to be vertically movable at a position between the first chase block 213 and the top plate 251 and at a position on the top plate 251 side with respect to the first support plate 215. In addition, as a modified example, the first eject plate 217 may be disposed at a position on the first chase block 213 side with respect to the first support plate 215 (not shown). This first ej ect plate 217 includes an eject pin (first eject pin) 235 and an eject plate operation pin 239 that are disposed and inserted through the first cavity plate 211, the first chase block 213 and the first support plate 215, and the first eject pin 235 is capable of abutting against the workpiece W and the eject plate operation pin 239 is capable of abutting against the mold surface 206a of the lower mold 206.

Moreover, an eject urging member (first eject urging member) 241 that urges the first eject plate 217 in a direction toward the first chase block 213 and the first support plate 215 is provided. Also, an urging member holder (first eject urging member holder) 243 that holds the first eject urging member 241 in a state of generating the urging force is provided and screwed onto the first chase block 213. Therefore, the first eject plate 217 is in a state of abutting against the first support plate 215 in the mold opened state. In addition, as an example, a coil spring made of metal is used as the first eject urging member 241, but the present invention is not limited thereto.

According to the above configuration, when the upper mold 204 (in this case, the first cavity plate 211) and the lower mold 206 (in this case, the second cavity plate 212) abut against each other (the mold closed state), the tip portion (the lower end portion) of the eject plate operation pin 239 abuts against the mold surface 206a of the lower mold 206 (in this case, the upper surface of the second cavity plate 212), and the reaction force thereof generates an effect of pushing the first eject plate 217 in a direction away from the first support plate 215. Thereby, the first eject plate 217 moves upward, and the first eject pin 235 fixed to the first eject plate 217 moves upward. That is, the first eject pin 235 can be prevented from abutting against the workpiece W when the mold is closed.

Conversely, when the bottom plate 252 is moved downward from the state where the upper mold 204 and the lower mold 206 abut against each other (the mold closed state) to shift to the mold opened state, since the contact between the tip portion (the lower end portion) of the eject plate operation pin 239 and the mold surface 206a of the lower mold 206 is released, the first eject plate 217 moves downward, and the first eject pin 235 fixed to the first eject plate 217 moves downward. Therefore, it is possible to eject (take out) the resin-sealed workpiece W (that is, the molded product Wp).

The upper mold 204 has been described above, but the upper mold 204 is provided with a compression coil spring 263 and a stepped bolt 264 that constantly urge the top plate 251 and the first chase block 213 in the opening direction. In addition, the stepped bolt 264 is screwed into the first chase block 213.

Next, the lower mold 206 of the sealing mold 202 will be described in detail. As shown in FIG. 2 and FIG. 3, the lower mold 206 includes a cavity plate (second cavity plate) 212, a chase block (second chase block) 214, etc., and is configured by assembling these. In this embodiment, a cavity (second cavity) 208 in which the entire workpiece W or a predetermined portion thereof is accommodated is provided on the upper surface of the second cavity plate 212. This second cavity plate 212 is fixed to the upper surface of the second chase block 214. In addition, the second cavity plate and the second chase block may be configured as an integral member (not shown). Further, the second chase block 214 is supported by a bottom plate 252 and fixed at a predetermined distance from the bottom plate 252. However, the present invention is not limited to the above configuration.

Here, the lower mold 206 is provided with a plurality of cylindrical pots (a case of four pots is illustrated as an example, but the present invention is not limited thereto; alternatively, there may be one single pot) along the front-rear direction, in which the resin (here, resin tablet) R is accommodated. The pot is formed as a through hole that is continuous in the second cavity plate 212 and the second chase block 214. Further, a plunger that is pushed by a known transfer drive mechanism (not shown) is disposed within the pot. With this configuration, the plunger is pushed to supply the resin R in the pot into the cavities 207 and 208. It should be noted that the pot and the plunger are omitted from illustration in order to make other mechanisms especially in FIG. 3 easier to understand.

Furthermore, the second cavity plate 212 or the second chase block 214 is provided with a lower mold heater (not shown). Thereby, the molten resin R filled in the resin flow path (not shown) and the cavity 208 can be heated to a predetermined temperature. As an example, a known heating wire heater, sheathed heater, or the like is used as the lower mold heater.

Further, the lower mold 206 includes a support plate (second support plate) 216 that is disposed at a position between the second chase block 214 and the bottom plate 252 so as to be vertically movable. The second support plate 216 includes a support member (second support pin) 222 that is disposed and inserted through the second cavity plate 212 and the second chase block 214 can support the workpiece W in a state of suspending the workpiece W from the bottom of the second cavity 208. In addition, although a plurality of second support pins 222 (for example, four) according to this embodiment are provided for supporting one workpiece W, the present invention is not limited thereto.

Furthermore, a support urging member (second support urging member) 232 that urges the second support plate 216 in a direction toward the second chase block 214 is provided. Also, an urging member holder (second support urging member holder) 234 that holds the second support urging member 232 in a state of generating the urging force is provided and screwed onto the second chase block 214. Thereby, the second support plate 216 is in a state of abutting against the second chase block 214 in the mold opened state. In addition, as an example, a coil spring made of metal is used as the second support urging member 232, but the present invention is not limited thereto.

Here, as a mechanism for operating the second support plate 216, a pushing pin (second support plate pushing pin) 225 that pushes the second support plate 216 in a direction away from the second cavity plate 212 is provided and supported by the top plate 251. As an example, the second support plate pushing pin 225 is configured to be directly supported (fixed) with respect to the top plate 251, but the present invention is not limited thereto, and may be configured to be indirectly supported (fixed) through a connecting member or the like (not shown).

According to the above configuration, when further bringing the top plate 251 and the bottom plate 252 close to each other from the state where the upper mold 204 (in this case, the second cavity plate 212) and the lower mold 206 (in this case, the second cavity plate 212) abut against each other (that is, the mold closed state), the second support plate pushing pin 225 supported (fixed) by the top plate 251 generates an effect that the second support plate 216 is pushed in a direction away from the second cavity plate 212. Thereby, the second support plate 216 moves downward, and the second support pin 222 fixed to the second support plate 216 moves downward. That is, the workpiece W can be released from support of the second support pin 222.

Here, the second support plate 216 includes a set pin (second set pin) 224 that is inserted through the second cavity plate 212 and the second chase block 214 and disposed to be capable of abutting against the second support plate pushing pin 225, and transmits the pushing force of the second support plate pushing pin 225 to the second support plate 216. That is, in this embodiment, the second support plate 216 is pushed indirectly via the second set pin 224 fixed to the second support plate 216, instead of being directly pushed by the second support plate pushing pin 225.

At this time, the second set pin 224 is preferably disposed so that a tip surface (in this case, the upper end surface) that abuts against the second support plate pushing pin 225 is in the same plane as the upper surface (that is, the mold surface 206a) of the second cavity plate 212 in a state of not abutting against the second support plate pushing pin 225. According to such a configuration, the tip portion of the second support plate pushing pin 225 does not protrude from the mold surface 204a in the mold opened state. Therefore, the amount of mold opening can be minimized, and an increase in takt time can be suppressed. Furthermore, even if malfunction or insufficient adjustment occurs, collision between the in loader 122, the out loader 124, and the second support plate pushing pin 225 can be prevented. In addition, the second set pin 224 is not necessary, and for example, the second support plate pushing pin 225 may protrude from the mold surface 204a and directly push the first support plate 216.

Furthermore, in this embodiment, a control pin (second support plate control pin) 227 that defines the amount of movement of the second support plate 216, that is, the pushing amount by which the second support plate pushing pin 225 pushes the second support plate 216 is provided. As an example, the second support plate control pin 227 is configured to be directly supported (fixed) with respect to the first chase block 213, but the present invention is not limited thereto, and the second support plate control pin 227 may be configured to be indirectly supported (fixed) through a connecting member or the like. Further, the second support plate control pin 227 may be supported (fixed) by the top plate 251 instead of the first chase block 213 (neither is shown).

According to this configuration, at a time point when the top plate 251 and the bottom plate 252 are further brought close to each other from the mold closed state and the second support plate 216 pushed by the second support plate pushing pin 225 moves downward by a predetermined amount, the second support plate control pin 227 abuts against the top plate 251 and generates an effect of regulating movement of the top plate 251 (that is, movement of the second support plate 216). Thereby, the amount of movement of the second support plate 216 (that is, the second support pin 222) is defined. In addition, in the case where the second support plate control pin 227 is supported (fixed) by the top plate 251, the second support plate control pin 227 abuts against the first chase block 213 and generates the same effect.

Next, the upper mold 204 includes an eject plate (second eject plate) 218 that is disposed to be vertically movable at a position between the second chase block 214 and the bottom plate 252 and at a position on the bottom plate 252 side with respect to the second support plate 216. In addition, as a modified example, the second eject plate 218 may be disposed at a position on the second chase block 214 side with respect to the second support plate 216 (not shown). This second eject plate 218 includes an eject pin (second eject pin) 236 that is disposed and inserted through the second cavity plate 212, the second chase block 214, and the second support plate 216, and is capable of abutting against the workpiece W.

Moreover, an eject urging member (second eject urging member) 242 that urges the second eject plate 218 in a direction away from the second chase block 214 and the second support plate 216 is provided. Also, a stopper 244 that defines the amount of movement by which the second eject plate 218 moves downward by the urging force of the second eject urging member 242 is provided and screwed onto the second chase block 214. Therefore, the second eject plate 218 is in a state of being spaced apart from the second support plate 216 by a predetermined distance in the mold closed state and in the state immediately after transition from mold closing to mold opening. In addition, as an example, a coil spring made of metal is used as the second eject urging member 242, but the present invention is not limited thereto.

Here, as a mechanism for operating the second eject plate 218, a second eject plate pushing pin that pushes the second eject plate 218 in a direction toward the second cavity plate 212 is provided at a position spaced apart by a predetermined distance below the bottom plate 252 in the press device 250 (not shown). According to this configuration, by moving the bottom plate 252 downward to shift from the state where the upper mold 204 and the lower mold 206 abut against each other (the mold closed state) to the mold opened state, and further moving the bottom plate 252 downward by a predetermined amount, the tip portion (the upper end portion) of the second eject plate pushing pin abuts against the lower surface of the second eject plate 218, and generates an effect that the second eject plate 218 is pushed in a direction toward the second support plate 216. Thereby, the second eject plate 218 moves upward, and the second eject pin 236 fixed to the second eject plate 218 moves upward. Therefore, it is possible to eject (take out) the resin-sealed workpiece W (that is, the molded product Wp).

As described above, this embodiment illustrates a configuration including support plates (the first support plate 215 of the upper mold 204, and the second support plate 216 of the lower mold 206) and support members (the first support pin 221 of the upper mold 204, and the second support pin 222 of the lower mold 206) in both the upper mold 204 and the lower mold 206 as an example, the present invention is not limited thereto. That is, only the upper mold 204 may be provided with a support plate and a support member (in that case, the lower mold 206 may have a conventional mold configuration or the like). Alternatively, only the lower mold 206 may be provided with a support plate and a support member (in that case, the upper mold 204 may have a conventional mold configuration or the like).

The lower mold 206 has been described above, but the lower mold 206 is provided with a compression coil spring 265 and a stepped bolt 266 that constantly urge the bottom plate 252 and the second chase block 214 in the opening direction. In addition, the stepped bolt 266 is screwed into the second chase block 214.

### (Storage unit)

Next, the storage unit 100C included in the resin sealing device 1 will be described.

As an example, the storage unit 100C includes a molded product table 114 on which the molded product Wp is placed, a gate break portion 116 that removes unnecessary resin parts such as the cull part, runner part, and gate part from the molded product Wp, and a molded product stocker 112 that is used to store the molded product Wp with unnecessary resin parts removed. In addition, the molded product stocker 112 uses a known stack magazine, slit magazine, or the like, and can accommodate multiple molded products Wp at once. With this configuration, the molded product Wp (in a state of being connected via the unnecessary resin parts) transported from the press unit 100B using the out loader 124, etc. is placed on the molded product table 114. Then, after being transferred to the gate break portion 116 using a known pickup or the like (not shown) and having unnecessary resin parts removed, the molded product Wp is stored in the molded product stocker 112 using a known pusher or the like (not shown).

### (Resin sealing operation)

Next, an operation of performing resin sealing using the resin sealing device 1 according to this embodiment (that is, the resin sealing method according to this embodiment) will be described. The configuration illustrated as an example here can perform resin sealing at once by arranging two workpieces W (for example, workpieces in the form of strips) in parallel to obtain two molded products Wp at the same time, using the resin sealing device 1 in which two pairs of cavities 207 and 208 are provided in one sealing mold 202. However, the present invention is not limited to this configuration, and the number of workpieces W and cavities 207 and 208 can be set as appropriate.

As a preparation step, a heating step (upper mold heating step) is performed in which the upper mold 204 is adjusted to a predetermined temperature (for example, 100°C to 200°C) and heated using the upper mold heater. Further, a heating step (lower mold heating step) is performed in which the lower mold 206 is adjusted to a predetermined temperature (for example, 100°C to 200°C) and heated using the lower mold heater.

Next, a step of taking out the workpieces W one by one from the workpiece stocker 102 using a known pusher or the like (not shown) and placing the workpieces W on the upper surface of the workpiece table 104 is performed (a known pickup mechanism or the like may be used in combination). Further, a step of taking out the tablet-shaped resin R one by one from the supply portion 142 using a known feeder, elevator, or the like (not shown) and holding a plurality of (for example, four) pieces of resin R at predetermined positions in the delivery portion 144 is performed.

Next, the in loader 122 is moved directly above the workpiece table 104 (may be on standby at the same position in advance). At that position, a step of raising the workpiece table 104 (or lowering the in loader 122) and holding the workpieces W with the workpiece holding portions 122A and 122B (in this embodiment, the workpiece holding portions 122A and 122B each hold one workpiece W) is performed.

Next, the in loader 122 is moved directly above the delivery portion 144. At that position, a step of raising the delivery portion 144 (or lowering the in loader 122) and holding the resin R with the resin holding portion 122C (in this embodiment, the resin holding portion 122C holds four pieces of resin R) is performed.

Next, a step of transporting a plurality of (in this embodiment, two) workpieces W and a plurality of (in this embodiment, four) pieces of resin R into the sealing mold 202 of the press unit 100B in one process using the in loader 122 and placing the workpieces W respectively at predetermined positions in the lower mold 206 (workpiece placement step), and a step of accommodating the resin R respectively in a plurality of (in this embodiment, four) pots (not shown) in the lower mold 206 (resin accommodating step) are performed. In addition, during the transportation, a step of preheating the workpieces W and the resin R using a heater (not shown) provided in the in loader 122 (preheating step) may be performed.

In the workpiece placement step according to this embodiment, as shown in FIG. 4, a step of placing the workpiece W on the upper surface of the tip portion (the upper end portion) of the second support pin 222 with the tip portion (the upper end portion) protruding into the second cavity 208 in the lower mold 206 in the mold opened state is performed.

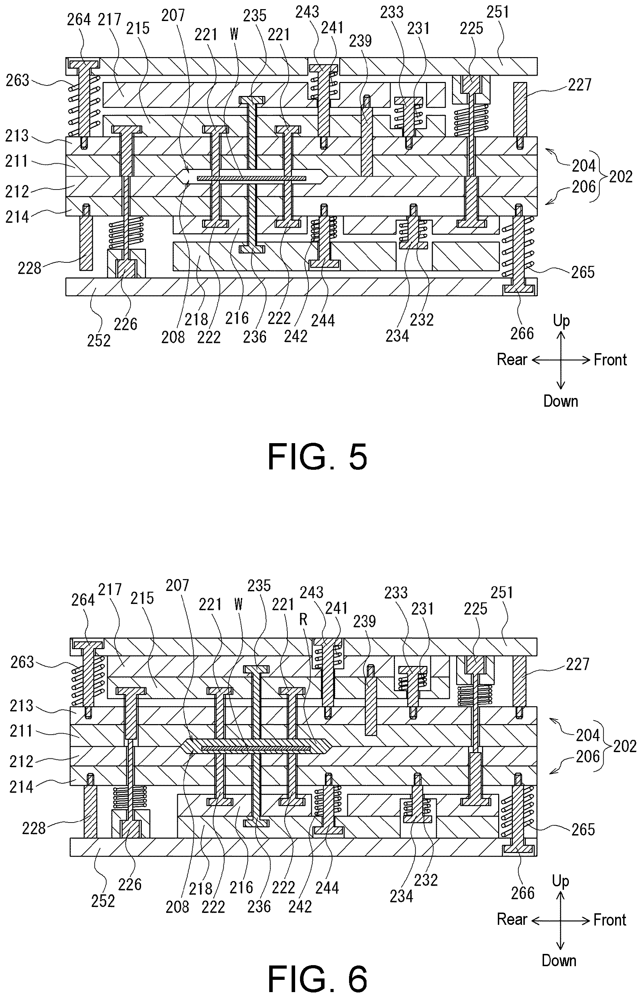

Next, as shown in FIG. 5, by raising the movable platen 254 and bringing the fixed platen 253 and the movable platen 254 close to each other, the mold surface 204a of the upper mold 204 and the mold surface 206a of the lower mold 206 abut against each other to close the sealing mold 202. At this time, regarding the upper mold 204, the tip portion (the lower end portion) of the eject plate operation pin 239 abuts against the mold surface 206a of the lower mold 206, the first eject plate 217 moves upward, and the first eject pin 235 moves upward (a state of not abutting against the workpiece W). Further, the lower surface of the tip portion (the lower end portion) of the first support pin 221 with the tip portion (the lower end portion) protruding into the first cavity 207 abuts against the workpiece W. Therefore, the workpiece W is clamped between the first support pin 221 and the second support pin 222, and is held in the cavities 207 and 208 in a state of floating from both the bottom of the first cavity 207 and the bottom of the second cavity 208.

In this state, a step of operating a transfer drive mechanism (not shown) to push a plunger (not shown) in a direction toward the upper mold 204 and pumping molten sealing resin through resin flow paths (not shown) such as culls and runners of the upper mold 204 to fill the cavities 207 and 208 (resin filling step) is performed.

In the resin filling step according to this embodiment, as shown in FIG. 6, when the filling rate of the resin R in the cavities 207 and 208 reaches an arbitrary set value (as an example, appropriately set from 70% to 100%), a step of further bringing the fixed platen 253 and the movable platen 254 close to each other from the mold closed state is performed. The timing of this second mold closing may be switched based on the height position of the transfer that pushes up the plunger, or may be switched based on the time from when the plunger is started to be pressed, but the present invention is not limited thereto.

At this time, the first support plate 215 is pushed in a direction away from the first cavity plate 211 by the first support plate pushing pin 226 supported (fixed) by the bottom plate 252 that is connected (joined) to the movable platen 254. Thereby, the first support plate 215 moves upward, and the first support pin 221 fixed to the first support plate 215 moves upward. That is, the workpiece W is released from support of the first support pin 221. Similarly, the second support plate 216 is pushed in a direction away from the second cavity plate 212 by the second support plate pushing pin 225 supported (fixed) by the top plate 251 that is connected (joined) to the fixed platen 253. Thereby, the second support plate 216 moves downward, and the second support pin 222 fixed to the second support plate 216 moves downward. That is, the workpiece W is released from support of the second support pin 222.

According to the above configuration, when the resin R reaches an appropriate filling rate (for example, a set value of 70% to 100%) in the cavities 207 and 208, resulting in a state where the workpiece W in the cavities 207 and 208 is covered with the resin R to the extent that the workpiece W is not displaced, the first support pin 221 is moved upward and the second support pin 222 is moved downward, making it possible to release support (clamping) of the workpiece W. Therefore, it is possible to prevent the supported (clamped) portion of the workpiece W from remaining exposed without being sealed with resin, which may cause problems. Furthermore, it is possible to solve the problem that the workpiece W, which is impossible or difficult to clamp, may be displaced from a predetermined position during the resin filling step. Particularly, in this embodiment, the above steps can be performed by a configuration that uses the drive mechanism for closing the mold without providing a large-scale dedicated drive mechanism, so the device structure can be simplified and the device cost can be suppressed.

Next, after the resin R is filled to 100% in the cavities 207 and 208, a step of heating for a predetermined time to seal the workpiece W with resin and process the workpiece W into the molded product Wp is performed.

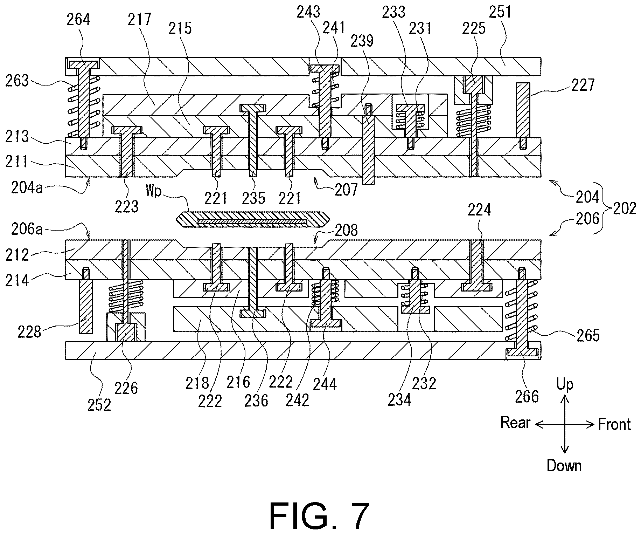

Next, as shown in FIG. 7, by lowering the movable platen 254, the fixed platen 253 and the movable platen 254 are separated to open the sealing mold 202. At this time, regarding the upper mold 204, the contact between the tip portion (the lower end portion) of the eject plate operation pin 239 and the mold surface 206a of the lower mold 206 is released, and the first eject plate 217 moves downward. Therefore, the first eject pin 235 fixed to the first eject plate 217 moves downward. Thereby, the resin-sealed molded product Wp is ejected from the first cavity 207. On the other hand, regarding the lower mold 206, the movable platen 254 is lowered by a predetermined amount, the second eject plate pushing pin (not shown) abuts against the lower surface of the second eject plate 218, and the second eject plate 218 moves upward. In addition, the movable platen 254 and the bottom plate 252 are provided with through holes through which the second eject plate pushing pin is inserted. Therefore, the second eject pin 236 fixed to the second eject plate 218 moves upward (not shown). Thereby, the resin-sealed molded product Wp is ejected from the second cavity 208.

Next, a step of taking out a plurality of (in this embodiment, two) molded products Wp (in a state of including unnecessary resin parts such as the cull parts and runner parts, and being connected via these) from the opened sealing mold 202 in one process using the out loader 124 is performed.

Next, a step of placing the molded products Wp (including the cull parts, runner parts, or the like) onto the molded product table 114 using the out loader 124 is performed (a known pickup mechanism or the like may be used in combination). Next, a step of removing unnecessary resin parts such as the cull parts and runner parts from the molded product Wp is performed in the gate break portion 116. Next, a step of transporting the molded products Wp (with unnecessary resin parts removed) one by one into the molded product stocker 112 using a known pusher or the like (not shown) is performed. In addition, before these steps, a step of post-curing the molded product Wp may be performed.

The above are the main operations of resin sealing performed using the resin sealing device 1. However, the above step order is merely an example, and the steps can be changed in order or performed in parallel as long as no problem occurs. For example, since the configuration in this embodiment includes two press units 100B, the above operations can be performed in parallel to achieve efficient molded product formation.

### [Second embodiment]

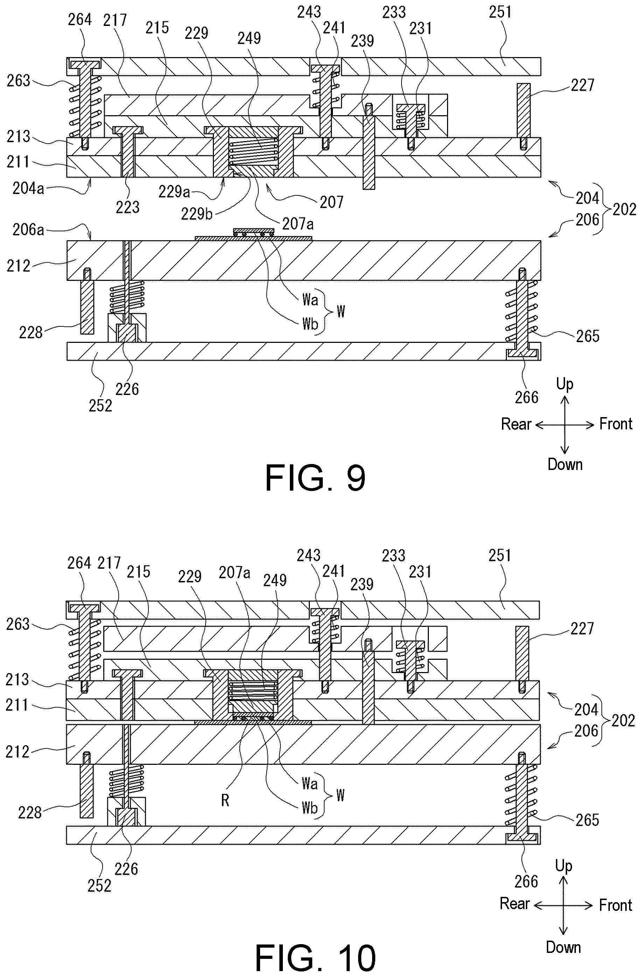

Next, the second embodiment of the present invention will be described. This embodiment is suitable for a flip chip or BGA type workpiece W having a space between the base material Wa and the electronic component Wb, for example, as shown in FIG. 8C, and has differences in the configuration of the sealing mold 202 compared to the first embodiment described above. The following will mainly describe the differences. Here, a side cross-sectional view (schematic view) of the sealing mold 202 according to the second embodiment is shown in FIG. 9.

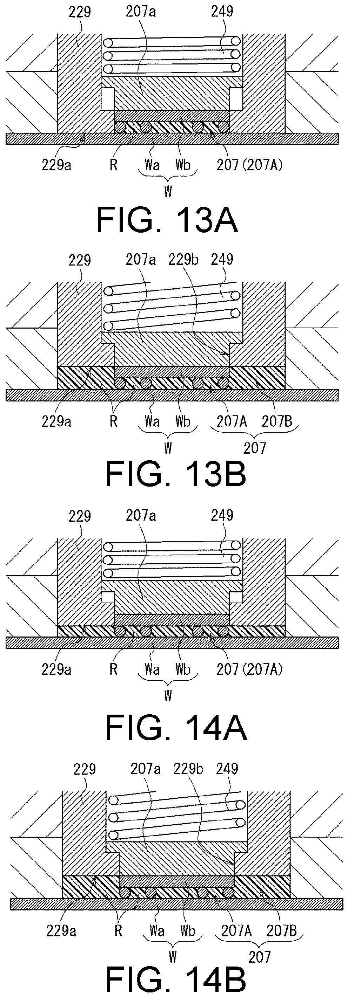

First, the upper mold 204 of the sealing mold 202 according to this embodiment will be described. As shown in FIG. 9, the upper mold 204 includes a support plate (first support plate) 215 that is disposed at a position between the first chase block 213 and the top plate 251 so as to be vertically movable. The first support plate 215 includes a support member (support block) 229 that is disposed and inserted through the first cavity plate 211 and the first chase block 213 and constitutes the cavity 207. This support block 229 is formed in a block shape (for example, a hollow square columnar shape corresponding to the shape of the electronic component Wb) that has a tip surface 229a abutting against the base material Wa (see FIG. 13A), or not abutting as a modified example (see FIG. 14A), with respect to the workpiece W, and has an inner peripheral surface 229b that can cover the peripheral edge portion of the electronic component Wb over a predetermined range (for example, the entire periphery excluding the runner part). In addition, an eject pin for taking out the molded product Wp may be provided to pass through the support block 229, may be provided to press the upper surface of the molded product Wp, or may be provided to press the base material Wa (neither is shown).

Furthermore, in this embodiment, the bottom of the cavity 207 is configured as a separate member (cavity bottom member 207a) having a T-shaped cross section, and a cavity bottom urging member 249 is provided to urge the cavity bottom member 207a toward the lower mold 206. According to this, the cavity bottom member 207a can abut against the upper surface of the electronic component Wb of the workpiece W while being urged by the cavity bottom urging member 249.

Next, the lower mold 206 of the sealing mold 202 according to this embodiment will be described. As shown in FIG. 9, the lower mold 206 includes a cavity plate (second cavity plate) 212 that is integrated with a chase block (second chase block). In addition, the second support plate, second eject plate, etc. according to the first embodiment described above are not essential.

Further, as a modified example of the sealing mold 202, the upper mold 204 and the lower mold 206 may be arranged upside down (not shown).

The operation of performing resin sealing using the resin sealing device 1 that includes the sealing mold 202 according to this embodiment described above (that is, the resin sealing method according to this embodiment) is different from the first embodiment described above, particularly in the following steps.

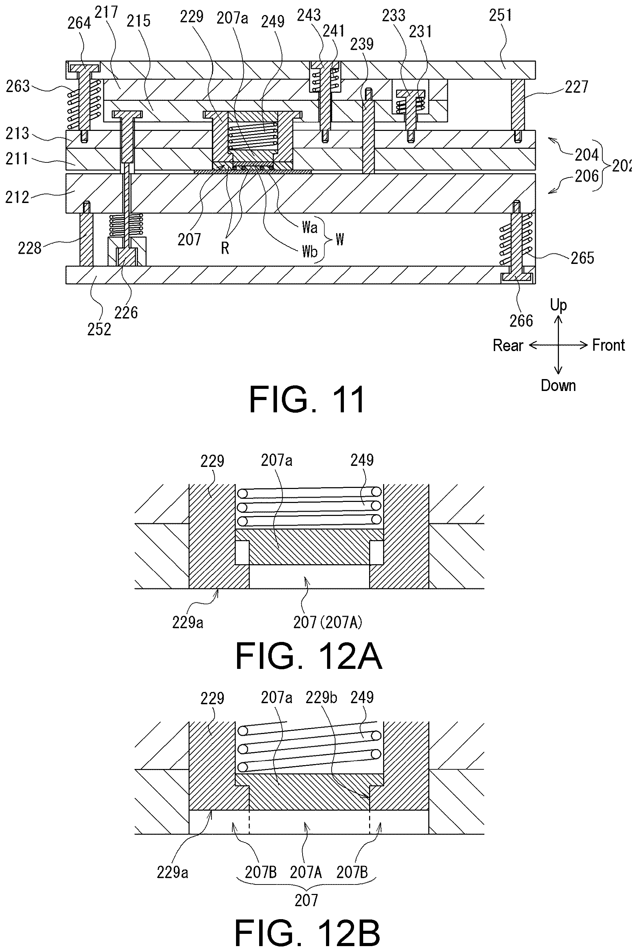

Specifically, as shown in FIG. 10, when the upper mold 204 (in this case, the first cavity plate 211) and the lower mold 206 (in this case, the second cavity plate 212) abut against each other (that is, the mold closed state), the workpiece W is supported with the base material Wa clamped between the lower surface (the mold surface 204a) of the first cavity plate 211 and the upper surface (the mold surface 206a) of the second cavity plate 212. Further, the cavity bottom member 207a is moved upward due to the thickness of the electronic component Wb and the flip chip joint portion, causing the urging member 249 to bend, and the inner peripheral surface 229b of the support block 229 covers the peripheral edge portion of the electronic component Wb over a predetermined range. The space 207A formed at this time becomes the first aspect of the cavity 207. Here, as enlarged views of the cavity 207 of the first aspect, a configuration in which the workpiece W is not illustrated is shown in FIG. 12A, a configuration in which the workpiece W is illustrated and the tip surface 229a of the support block 229 abuts against the upper surface of the base material Wa is shown in FIG. 13A, and a configuration in which the workpiece W is illustrated and the tip surface 229a of the support block 229 does not abut against the upper surface of the base material Wa is shown in FIG. 14A as a modified example.

In this state, a transfer drive mechanism (not shown) is operated to push a plunger (not shown) in a direction toward the upper mold 204 and pump molten resin R through resin flow paths (not shown) such as culls and runners of the upper mold 204, thereby filling the resin R into the cavity 207 of the first aspect. Therefore, the narrow space between the base material Wa and the electronic component Wb can be filled with the resin R without creating a gap (void) in a state where the peripheral edge portion of the electronic component Wb is covered. In addition, the upper surface of the electronic component Wb against which the cavity bottom member 207a abuts is formed in an exposed state.

When further brining the top plate 251 and the bottom plate 252 close to each other from the above state (that is, the mold closed state) as shown in FIG. 11, the first support plate 215 is pushed in a direction away from the first cavity plate 211 by the first support plate pushing pin 226 supported (fixed) by the bottom plate 252. Thereby, the first support plate 215 moves upward, and the support block 229 fixed to the first support plate 215 moves upward. Therefore, the state in which the peripheral edge portion of the electronic component Wb is covered by the inner peripheral surface 229b of the support block 229 is released (in this embodiment, the state in which the cavity bottom member 207a abuts against the upper surface of the electronic component Wb is not released). The space 207B additionally formed at this time and the space 207A described above combine to become the second aspect of the cavity 207. Here, as enlarged views of the cavity 207 of the second aspect, a configuration in which the workpiece W is not illustrated is shown in FIG. 12B, a configuration in which the workpiece W is illustrated and the tip surface 229a of the support block 229 abuts against the upper surface of the base material Wa is shown in FIG. 13B, and a configuration in which the workpiece W is illustrated and the tip surface 229a of the support block 229 does not abut against the upper surface of the base material Wa is shown in FIG. 14B as a modified example.

In this state, the transfer drive mechanism (not shown) is further operated to push the plunger (not shown) in a direction toward the upper mold 204 and pump the molten resin R through the resin flow paths (not shown) such as culls and runners of the upper mold 204, thereby filling the resin R into the cavity 207 of the second aspect. Therefore, the base material Wa can be sealed with the resin R so that a predetermined portion of the electronic component Wb is covered.

Thus, with the sealing mold 202 according to this embodiment, so-called mold underfill molding can be suitably performed. That is, with the configuration of the first stage shown in FIG. 10, the resin R can be reliably filled without creating a gap (void) between the base material Wa and the electronic component Wb where the resin R is difficult to enter. Then, with the configuration of the second stage shown in FIG. 11, the electronic component Wb, having the upper surface exposed, can be sealed with the resin R to cover a predetermined portion thereof, and can be processed into the final product (that is, the molded product Wp). Therefore, the quality of the product (the molded product Wp) can be further improved.

It should be noted that the other configurations of this embodiment are the same as those of the first embodiment described above, and repeated description will be omitted. Further, although the workpiece W in the second embodiment has one electronic component Wb arranged on the base material Wa, in the case where the workpiece W has a plurality of electronic components Wb arranged in a matrix on the base material Wa, the support block 229 may be provided independently for each electronic component Wb, or may be provided as an integral structure having a cavity 207 (that is, the cavity bottom member 207a) at a corresponding position for each electronic component Wb (neither is shown).

As described above, with the resin sealing device, the sealing mold, and the resin sealing method according to the present invention, the workpiece can be clamped and released using the vertically movable support member, so the workpiece can be sealed with resin without shifting from the predetermined position. In addition, since the vertical movement mechanism of the support member can be realized by a configuration that uses the mold closing mechanism provided in the press device, without providing a large-scale dedicated drive mechanism, the device structure can be simplified and the device cost can be suppressed. Furthermore, mold underfill molding can be suitably performed.

Nevertheless, the present invention is not limited to the above-described embodiments, and various changes can be made without departing from the scope of the present invention. Specifically, although the first embodiment illustrates a configuration in which the support plates and support members are provided in both the upper mold and the lower mold as an example, the present invention is not limited thereto, and the support plates and support members may be provided in only the upper mold or only the lower mold. In addition, although the second embodiment illustrates a configuration in which the support plate and support member are provided in only the upper mold as an example, the present invention is not limited thereto, and the support plates and support members may be provided in only the lower mold or in both the upper mold and the lower mold.

Furthermore, in the upper mold, the first eject plate is arranged on the first support plate, but these may be arranged upside down. Similarly, in the lower mold, the second eject plate is arranged below the second support plate, but these may be arranged upside down.

## Claims

1. A sealing mold, comprising an upper mold and a lower mold and processing a workpiece into a molded product by sealing the workpiece with resin, the sealing mold comprising:
a cavity plate which is disposed in at least one of the upper mold and the lower mold and has a cavity;
a chase block to which the cavity plate is fixed or which is formed integrally with the cavity plate;
one plate of a top plate and a bottom plate of upper and lower molds which applies a pushing force to the chase block in a direction of performing mold closing of the upper mold and the lower mold;
an other plate which is disposed in pair with the one plate and operates together to perform the mold closing; and
a support plate which is disposed at a position between the chase block and the one plate to be vertically movable,
wherein the support plate comprises a support member that is disposed and inserted through the cavity plate and the chase block and supports the workpiece, and
a pushing pin that pushes the support plate in a direction away from the cavity plate in response to the one plate and the other plate being further brought close to each other from a mold closed state is provided to be supported by the other plate.

2. The sealing mold according to claim 1, further comprising a support urging member that urges the support plate in a direction toward the chase block.

3. The sealing mold according to claim 1 or 2, further comprising a control pin that regulates movement of the other plate to define a pushing amount by which the pushing pin pushes the support plate in response to the one plate and the other plate being further brought close to each other from the mold closed state.

4. The sealing mold according to claim 1 or 2, wherein the support plate comprises a set pin that is inserted through the cavity plate and the chase block and disposed to be capable of abutting against the pushing pin and transmits a pushing force of the pushing pin to the support plate.

5. The sealing mold according to claim 4, wherein the set pin is disposed so that a tip surface that abuts against the pushing pin is in the same plane as a mold surface of the cavity plate.

6. The sealing mold according to claim 1 or 2, further comprising an eject plate that is disposed to be vertically movable at a position between the chase block and the one plate and at a position on either the chase block side or the one plate side with respect to the support plate,
wherein the eject plate comprises an eject pin that is inserted through the cavity plate and the chase block to be capable of abutting against the molded product.

7. A sealing mold, comprising an upper mold and a lower mold and processing a workpiece into a molded product by sealing the workpiece with resin, the sealing mold comprising:
a cavity plate which is disposed in the upper mold and has a cavity;
a chase block to which the cavity plate is fixed or which is formed integrally with the cavity plate;
one plate of a top plate and a bottom plate of upper and lower molds which applies a pushing force to the chase block in a direction of performing mold closing of the upper mold and the lower mold;
an other plate which is disposed in pair with the one plate and operates together to perform the mold closing; and
a support plate which is disposed at a position between the chase block and the one plate to be vertically movable,
wherein the support plate comprises a support member that is disposed and inserted through the cavity plate and the chase block and forms the cavity, and
a pushing pin that pushes the support plate in a direction away from the cavity plate in response to the one plate and the other plate being further brought close to each other from a mold closed state is provided to be supported by the other plate.

8. A sealing mold, comprising an upper mold and a lower mold and processing a workpiece into a molded product by sealing the workpiece with resin, the sealing mold comprising:
a cavity plate which is disposed in the lower mold and has a cavity;
a chase block to which the cavity plate is fixed or which is formed integrally with the cavity plate;
one plate of a top plate and a bottom plate of upper and lower molds which applies a pushing force to the chase block in a direction of performing mold closing of the upper mold and the lower mold;
an other plate which is disposed in pair with the one plate and operates together to perform the mold closing; and
a support plate which is disposed at a position between the chase block and the other plate to be vertically movable,
wherein the support plate comprises a support member that is disposed and inserted through the cavity plate and the chase block and forms the cavity, and
a pushing pin that pushes the support plate in a direction away from the cavity plate in response to the one plate and the other plate being further brought close to each other from a mold closed state is provided to be supported by the one plate.

9. A resin sealing device, comprising the sealing mold according to any one of claims 1 to 8.

10. A resin sealing method, for processing a workpiece into a molded product by sealing the workpiece with resin using a resin sealing device that comprises:
a cavity plate which is disposed in at least one of an upper mold and a lower mold that form a sealing mold and has a cavity;
a chase block to which the cavity plate is fixed;
one plate of a top plate and a bottom plate of upper and lower molds which pushes the chase block;
an other plate which is disposed in pair with the one plate and operates together to perform mold closing of the sealing mold; and
a support plate which is disposed at a position between the chase block and the one plate to be vertically movable,
the resin sealing method comprising:
a step of supporting the workpiece in a state of floating from a bottom of the cavity using a support member that is disposed on the support plate;
next, a step of performing mold closing of the sealing mold by bringing the one plate and the other plate close to each other;
next, a step of filling the resin into the cavity; and
next, a step of pushing the support plate in a direction away from the cavity plate using a pushing pin disposed on the other plate to release the workpiece from support of the support member by further bringing the one plate and the other plate close to each other from a mold closed state in response to a filling rate of the resin in the cavity reaches an arbitrary set value of 70% to 100%.
